# EUROPEAN PATENT APPLICATION

(11) **EP 4 804 417 A1**
(43) Date of publication of application: **09.09.2026**
(21) Application number: 26162049.6
(22) Date of filing: 03.03.2026
(51) Int. Cl.: H04B 3/00

(54) **ELECTRONIC INTERFACE FOR A BIDIRECTIONAL ONE-WIRE COMMUNICATION LINE WITH DATA OUTPUT OF FEEDBACK BITS ONLY ON DEMAND**

(30) Priority: 07.03.2025 AT 501462025; 10.03.2025 AT 501512025
(71) Applicant: Swarovski-Optik AG & Co KG., 6067 Absam (AT)
(72) Inventor: KLINGENSCHMID, Lukas, 6112 Wattens (AT); MUIGG, Julian, 6020 Innsbruck (AT); HERMANN, Herbert, 6060 Hall in Tirol (AT)
(74) Representative: Burger, Hannes Alfred

(57) **Abstract**

The invention relates to an electronic interface (1..1‴, 1a, 1b) for a bidirectional one-wire communication line (2) and comprises a sender unit (3, 3') with a line output (LNOUT, LNOUT') to be connected to the communication line (2), a receiver unit (4, 4') with a line input (LNIN, LNIN') to be connected to the communication line (2), a data input (DIN..DIN"') for a data signal having sending data bits, which are to be sent over the communication line (2) via the sender unit (3, 3'), and a data output (DOUT..DOUT"') for a data signal having received data bits, which are received over the communication line (2) via the receiver unit (4, 4'). The electronic interface (1..1‴, 1a, 1b) and an associated method are designed to forward a feedback bit, which is sent by the sender unit (3, 3') and fed back to and received by the receiver unit (4, 4'), to the data output (DOUT..DOUT‴) only on demand. Further on, the invention relates to a communication system (9a, 9b) with an electronic interface (1..1‴, 1a, 1b) of the proposed kind.

## Description

### BACKGROUND OF THE INVENTION

The invention relates to an electronic interface for a bidirectional one-wire communication line, wherein the electronic interface comprises a sender unit (or transmitter unit respectively), a receiver unit, a data input and a data output. The sender unit has a line output, which is designed to be (physically) connected to the one-wire communication line, and the receiver unit has a line input, which is designed to be (physically) connected to the one-wire communication line as well. The data input is provided for a data signal having sending data bits, which are to be sent over the one-wire communication line via the sender unit, and the data output is provided for a data signal having received data bits, which are received over the one-wire communication line via the receiver unit. The electronic interface is designed to forward a feedback bit, which is sent by the sender unit and fed back to and received by the receiver unit, to the data output. Sending data bits can be amplified by the sender unit, which may also be called "sender stage", and received data bits can be amplified by the receiver unit, which may also be called "receiver stage".

In addition, the invention relates to a communication system, which comprises an electronic interface of the aforementioned kind, which forms a first electronic interface, a bidirectional one-wire communication line, which the line output of the sender unit and the line input of the receiver unit of the first electronic interface are connected to, and at least one second electronic interface. The at least one second electronic interface comprises a sender unit with a line output, which is (physically) connected to the one-wire communication line, a receiver unit with a line input, which is (physically) connected to the one-wire communication line, a data input for a data signal having sending data bits, which are to be sent over the one-wire communication line via the sender unit, and a data output for a data signal having received data bits, which are received over the one-wire communication line via the receiver unit.

Finally, the invention relates to a method for sending and receiving data over a bidirectional one-wire communication line by means of an electronic interface having a sender unit (or transmitter unit respectively), a receiver unit, a data input and a data output, in particular by means of an electronic interface as defined hereinbefore, wherein the method comprises the following steps:
- sending over the one-wire communication line via the sender unit, which is (physically) connected to the one-wire communication line with a line output, a data signal having sending data bits, wherein the sending data bits are input at a data input of the electronic interface, and
- receiving a data signal having received data bits, which are received over the one-wire communication line via the receiver unit, which is (physically) connected to the one-wire communication line with a line input, wherein the received data bits are output at the data output.

Generally, the electronic interface is used for communication with another communication entity, which is connected to the one-wire communication line, too. In particular, the electronic interface can be a first electronic interface, which is used for communication with at least one second electronic interface in the aforementioned communication system. Accordingly, sending data bits are sent to said communication entity or to the at least one second electronic interface respectively and received there. Equivalently, the communication entity or the at least one second electronic interface can send data to the (first) electronic interface. Such received data bits are provided at the data output of the (first) electronic interface.

However, the sending data bits, which are sent over the one-wire communication line, are not only received by said (distant) communication entity or the at least one second electronic interface respectively but also by the receiver unit of the presented electronic interface itself. These data bits are termed "feedback bits" (also known as "echo bits") in this disclosure. In contrast, data bits, which are received by the receiver unit and do not originate from the sender unit (but come from said distant communication entity or the at least one second electronic interface respectively) are termed "foreign bits" in this disclosure.

Generally, the received data bits provided at the data output can be processed in an application circuit, which is connected to the data output. This application circuit has to deal both with foreign bits and feedback bits or in other words has to distinguish between foreign bits and feedback bits. During normal operation, feedback bits usually form useless data. In contrast, feedback bits can form useful data for testing purposes. For example, feedback bits can be used for testing the sending and receiving branch of the electronic interface and the one-wire communication line. If a bit is sent by the sender unit, an application circuit or a software provided for processing received data "knows" that this (feedback) bit is expected at the receiver unit. So, if the feedback bit is not received although it has been sent, something is wrong in the electronic circuit or at its connection to the one-wire communication line.

Distinguishing between foreign bits and feedback bits, for example, can be done by means of a dedicated flag, by means of a software interrupt or by adding a sending address to sending data. For example, software procedures provided for processing received data (receiving software) can be blocked by a flag, which is set and reset by a software procedure provided for sending data (sending software). This is particularly useful, if the application circuit is connected both to the data input and the data output of the electronic interface and sending and receiving data is handled in a common software application. In case that there are different application circuits with different software applications, for example, blocking the receiving software can be achieved by an interrupt, which is sent by the sending software. In case that the sending software adds its address to a message sent over the one-wire communication line, the receiving software may judge on this address if the received data is relevant or not. In any case, handling feedback bits needs considerable effort in the software of the application circuit(s) connected to the electronic interface. In addition, this handling may lead to unexpected errors and deadlocks if it is not carefully programmed.

### SUMMARY OF THE INVENTION

Thus, it is an object of the invention to overcome the above drawbacks and to provide an improved electronic interface, an improved communication system and an improved communication method. In particular, a solution shall be provided, which allows handling of feedback bits with less requirements on the software of an application circuit connected to the electronic interface.

The inventive problem is solved by an electronic interface as defined in the opening paragraph, wherein the electronic interface is designed to forward a feedback bit to the data output only on demand.

Moreover, the inventive problem is solved by a communication system as defined in the opening paragraph, wherein the first electronic interface is embodied as defined above.

Finally, the inventive problem is solved by a method as defined in the opening paragraph, wherein a feedback bit, which is sent by the sender unit and fed back to and received by the receiver unit, is forwarded to the data output only on demand.

By use of the proposed measures, forwarding feedback data to the data output can be blocked so that an application circuit or a software provided for processing received data (receiving software) does not even receive feedback data. Hence, during normal operation, the application circuit or a receiving software does only receive foreign bits and no complicated software blocking is needed. On the other hand, if needed, testing the sending and receiving branch of the electronic interface and the one-wire communication line is possible if forwarding feedback data is enabled. In a nutshell, the proposed measures allow for easy handling of feedback data and for both processing received data during normal operation and for testing with only low requirements on the software of an application circuit connected to the electronic interface. In particular, there is no need for dedicated blocking flags, for software interrupts or for adding a sending address to sending data in this context.

Further details and advantages of the proposed electronic interface, the proposed method and the proposed communication system will become apparent in the following description and the accompanying drawings.

It is particularly useful if the electronic interface is designed to forward to the data output a foreign bit independent of if the feedback bit is forward to the data output or not. In other words, the electronic interface advantageously may be designed to forward a foreign bit to the data output in any case. Accordingly, foreign data is not lost, even if the application circuit or a receiving software is in the testing mode, where feedback bits are forwarded to the data output (too).

Advantageously, the electronic interface can comprise an enable input and can be designed to forward the feedback bit to the data output dependent on the logic state of an enable signal at the enable input. Equivalently, the proposed method may comprise the step of forwarding the feedback bit to the data output dependent on the logic state of an enable signal at an enable input of the electronic interface. By the proposed measures, the forwarding feature can easily be switched on or off by a dedicated signal fed to the enable input.

Advantageously, the electronic interface can be designed to forward the foreign bit to the data output independently of the logic state of the enable signal. Equivalently, the proposed method may comprise the step of forwarding the foreign bit to the data output independently of the logic state of the enable signal. Accordingly, foreign data is not lost, even if the forwarding feature is switched on at the enable input.

In another advantageous embodiment, the electronic interface in a case a) can comprise a look up table or in a case b) can comprise a logic circuit each with a first logic input L_{IN1} for the received data bits, a second logic input L_{IN2} for the sending data bits, a third logic input L_{IN3} for the enable signal and a logic output L_{OUT} for the data output, wherein the table content of the look up table in case a) or the logic function of the logic circuit in case b) based on positive logic is

| L_{IN3} | LIN2 | L_{IN1} | L_{OUT} |
|---|---|---|---|
| 1 | 1 | 1 | 1 |
| 1 | 1 | 0 | 0 |
| 1 | 0 | 1 | 1 |
| 1 | 0 | 0 | 0 |
| 0 | 1 | 1 | 0 |
| 0 | 1 | 0 | 0 |
| 0 | 0 | 1 | 1 |
| 0 | 0 | 0 | 0 |

or based on negative logic is

| L_{IN3} | LIN2 | L_{IN1} | L_{OUT} |
|---|---|---|---|
| 0 | 0 | 0 | 0 |
| 0 | 0 | 1 | 1 |
| 0 | 1 | 0 | 0 |
| 0 | 1 | 1 | 1 |
| 1 | 0 | 0 | 1 |
| 1 | 0 | 1 | 1 |
| 1 | 1 | 0 | 0 |
| 1 | 1 | 1 | 1 |

Equivalently, in the proposed method, the feedback bit and the foreign bit can be forwarded to the data output based on a logic function with a first logic input L_{IN1} for the received data bits, a second logic input L_{IN2} for the sending data bits, a third logic input L_{IN3} for the enable signal and a logic output L_{OUT} for the data output, wherein the logic function is of the aforementioned kind. In this context, the term "logic function" may be seen as a general term for the aforementioned look up table and the logic circuit. Accordingly, the electronic interface can comprise a logic function of the aforementioned kind.

In the communication system, the at least one second electronic interface may be designed to forward a feedback bit, which is sent by the sender unit and fed back to and received by the receiver unit of the at least one second electronic interface, to the data output of the at least one second electronic interface only on demand. Accordingly, the at least one second electronic interface can benefit from the same advantages as the first electronic interface.

In another embodiment, the communication system can comprise
- a first application circuit connected to the first electronic interface via the data input and the data output of the first electronic interface and/or
- at least one second application circuit connected to an associated second electronic interface via the data input and the data output of the associated second electronic interface.

In this way, the interfacing function is provided to the application circuit(s). It should be noted that the electronic interface and the associated application circuit may be embodied as separate physical modules or in a common physical module, in particular on separate circuit boards or on a common circuit board. It should also be noted that the first application circuit and its first electronic interface and the at least one second application circuit and its second electronic interface can be arranged on separate circuit boards or on a common circuit board. In the latter case, the one-wire communication line can be seen as an intra-module communication line.

In yet another embodiment of the communication system
- the first electronic interface can have an enable input of the aforementioned kind, wherein the first application circuit is connected to the first electronic interface via the enable input of the first electronic interface and/or
- the at least one second electronic interface can have an enable input of the aforementioned kind, wherein the associated second application circuit is connected to said second electronic interface via the enable input of said second electronic interface.

Accordingly, the first electronic interface can be set to forwarding mode by the first application circuit easily. Likewise, the at least one second electronic interface can be set to forwarding mode by the associated second application circuit easily.

Generally, the electronic interface(s) can be seen or embodied as a universal asynchronous receiver-transmitter (UART). A UART is a device for asynchronous serial data communication, wherein the data format and the transmission speed can be configurable. A UART sends data bits one by one framed by start and stop bits. The electric signaling levels can be handled by the UART or can be handled by a driver circuit external to the UART. Signal levels can be set or chosen according to standards RS-232, RS-485, and raw TTL for example.

To obtain a single one-wire communication line, generally, the line output of the sender unit and the line input of the receiver unit
- can be externally connected within the electronic interface,
- can be internally connected within the electronic interface or
- can be connected via a switchable connection (in particular within the electronic interface).

By use of a switch, the line output can be connected to the line input on demand. It should also be noted that an internal connection of the line output and the line input does not exclude an external connection of the same.

### BRIEF DESCRIPTION OF DRAWINGS

The invention now is described in more detail hereinafter with reference to particular embodiments, which the invention however is not limited to.
- Fig. 1: shows a schematic view of a first example of an electronic interface;
- Fig. 2: shows an exemplary look up table performing the proposed logic function based on positive logic;
- Fig. 3: shows an exemplary logic circuit performing the proposed logic function based on positive logic;
- Fig. 4: shows an exemplary logic circuit performing the proposed logic function based on negative logic;
- Fig. 5: shows a cutout of another exemplary electronic interface with internally connected line output and line input;
- Fig. 6: shows a cutout of yet another exemplary electronic interface with a switchable connection between the line output and line input;
- Fig. 7: shows a schematic view of a first exemplary communication system with a single second electronic interface and a single second application circuit and
- Fig. 8: shows a schematic view of another exemplary communication system with a plurality of second electronic interfaces and second application circuits.

### DETAILED DESCRIPTION

Generally, same parts or similar parts are denoted with the same/similar names and reference signs. The features disclosed in the description apply to parts with the same/similar names respectively reference signs. Indicating the orientation and relative position is related to the associated figure.

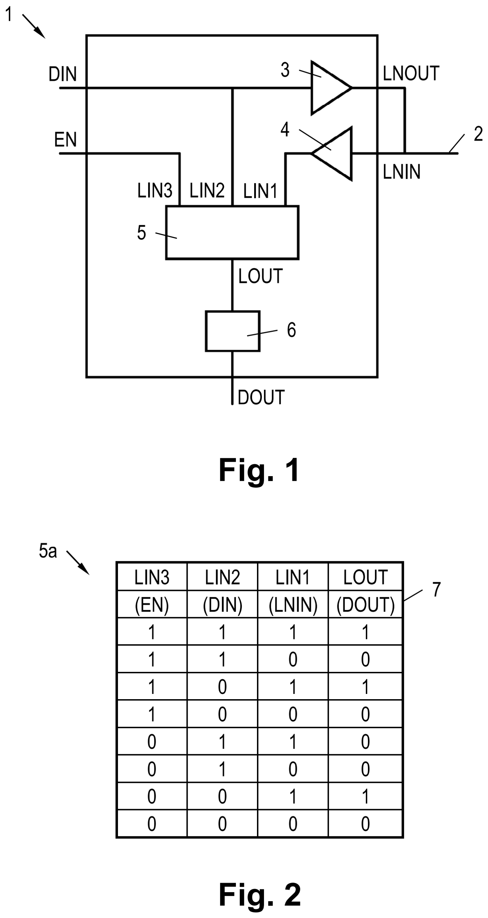

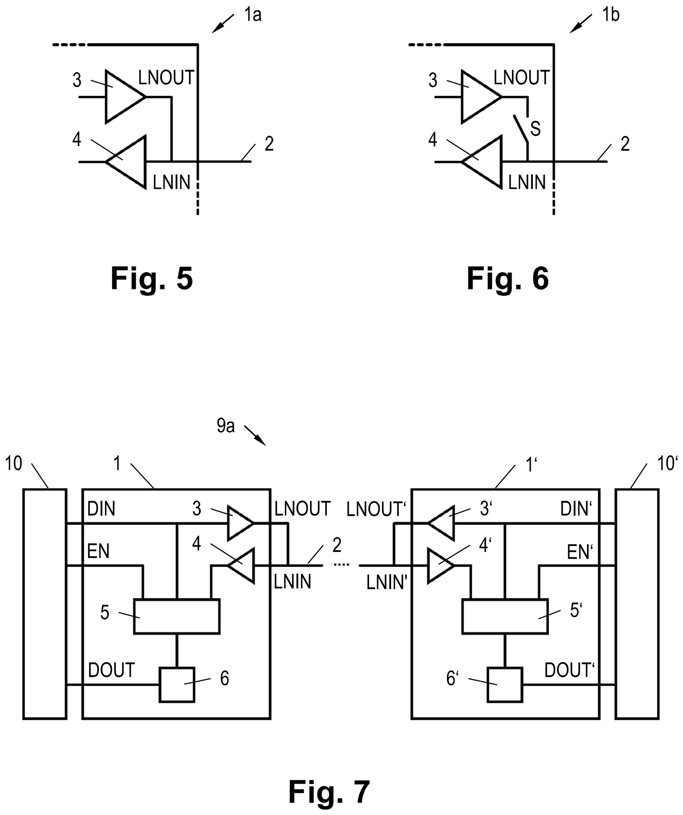

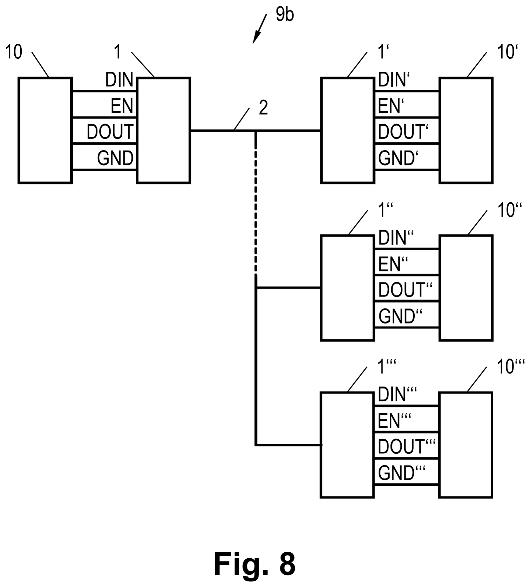

Fig. 1 shows a schematic view of a first example of an electronic interface 1 for a bidirectional one-wire communication line 2. The electronic interface 1 comprises a sender unit 3 with a line output LNOUT, which is designed to be (physically) connected to the one-wire communication line 2, and a receiver unit 4 with a line input LNIN, which is designed to be (physically) connected to the one-wire communication line 2, too. Further on, the electronic interface 1 comprises a data input DIN for a data signal having sending data bits, which are to be sent over the one-wire communication line 2 via the sender unit 3, and a data output DOUT for a data signal having received data bits, which are received over the one-wire communication line 2 via the receiver unit 4. Sending data bits, which can be provided by an application circuit connected to the data input DIN, are amplified by the sender unit 3 (which may also be called "sender stage") and sent to a communication entity, which is connected to the communication line 2, too (do also see Figs. 7 and 8 in this context). Equivalently, received data bits, which are received from said communication entity over the one-wire communication line 2 are amplified by the receiver unit 4 (which may also be called "receiver stage") and provided at the data output DOUT. Accordingly, said application circuit may also be connected to the data output DOUT. However, the application circuit connected to the data input DIN may also be different from the application circuit connected to the data output DOUT.

As can be envisaged from Fig. 1, the sending data bits, which are sent over the one-wire communication line 2 are not only received by the non-shown communication entity but also by the receiver unit 4 of the electronic interface 1 itself. These data bits are termed "feedback bits" in this disclosure. In contrast, data bits, which are received by the receiver unit 4 and do not originate from the sender unit 3 are termed "foreign bits" in this disclosure.

The electronic interface 1 is designed to forward a feedback bit, which is sent by the sender unit 3 and fed back to and received by the receiver unit 4, to the data output DOUT only on demand. In contrast, the electronic interface 1 advantageously may be designed to forward to the data output DOUT a foreign bit independent of if the feedback bit is forward to the data output DOUT or not. In other words, the electronic interface 1 advantageously may be designed to forward a foreign bit to the data output DOUT in any case. Accordingly, foreign data is not lost, even if feedback bits are suppressed.

For the above reasons, the electronic interface 1 advantageously can comprise an enable input EN, wherein the electronic interface 1 is designed to forward the feedback bit to the data output DOUT dependent on the logic state of an enable signal at the enable input EN. Additionally, the electronic interface 1 can be designed to forward the foreign bit to the data output DOUT independently of the logic state of the enable signal. In this way, the forwarding feature can easily be switched on or off by a dedicated signal fed to the enable input EN.

In the example of Fig. 1 the electronic interface 1 comprises a logic function 5 with a first logic input LIN1 for the received data bits (which is connected to the output of the receiver unit 4 for this reason), a second logic input LIN2 for the sending data bits (which is connected to the data input DIN for this reason), a third logic input LIN3 for the enable signal (which is connected to the enable input EN for this reason) and a logic output LOUT for the data output DOUT (which is connected to the data output DOUT via an optional filter 6 for this reason).

A logic function 5a can be embodied as a look up table 7 of the electronic interface 1, which is shown in detail in Fig. 2. The look up table 7 comprises a first logic input LIN1 for the received data bits, a second logic input LIN2 for the sending data bits, a third logic input LIN3 for the enable signal and a logic output LOUT for the data output DOUT. Concretely, the look up table 7 shows the logic function 5a based on positive logic.

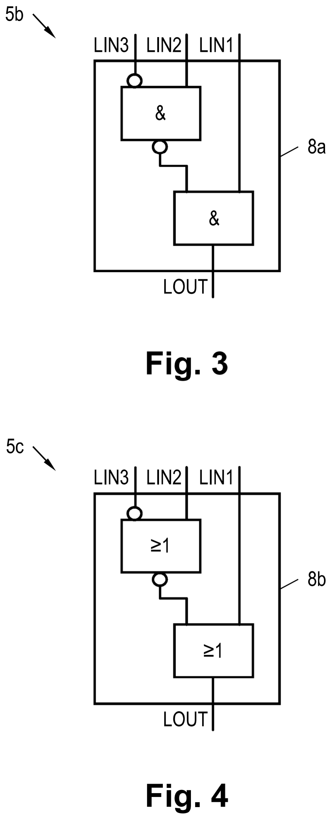

Alternatively, a logic function 5b (based on positive logic) can be embodied as a logic circuit 8a of the electronic interface 1, for which an example is shown in detail in Fig. 3. The logic circuit 8a comprises a first logic input LIN1 for the received data bits, a second logic input LIN2 for the sending data bits, a third logic input LIN3 for the enable signal and a logic output LOUT for the data output DOUT, too. Concretely, the look up table or truth table 7 shows the logic function 5b based on positive logic.

In an alternative embodiment, the logic function 5 can be based on negative logic, which then is

| LIN3 | LIN2 | LIN1 | LOUT |
|---|---|---|---|
| 0 | 0 | 0 | 0 |
| 0 | 0 | 1 | 1 |
| 0 | 1 | 0 | 0 |
| 0 | 1 | 1 | 1 |
| 1 | 0 | 0 | 1 |
| 1 | 0 | 1 | 1 |
| 1 | 1 | 0 | 0 |
| 1 | 1 | 1 | 1 |

Accordingly, the look up table 7 of Fig. 2 can have the above content in such a case. Equivalently, such a logic function 5c (based on negative logic) can be embodied as a logic circuit 8b of the electronic interface 1, for which an example is shown in detail in Fig. 4.

A method of operating the electronic interface 1 can comprise the following steps:
- sending over the one-wire communication line 2 via the sender unit 3 a data signal having sending data bits, which are input at a data input DIN,
- receiving a data signal having received data bits via the receiver unit 4 and output the received data bits at the data output DOUT, and
- forwarding to the data output DOUT a feedback bit, which is sent by the sender unit 3 and fed back to and received by the receiver unit 4, only on demand.

The method can also comprise the following optional method steps:
- forwarding to the data output DOUT a foreign bit, which is received by the receiver unit 4 and does not originate from the sender unit 3, independent of if the feedback bit is forward to the data output DOUT or not,
- forwarding the feedback bit to the data output DOUT dependent on the logic state of the enable signal at the enable input EN of the electronic interface 1 and/or
- forwarding the foreign bit to the data output DOUT independently of the logic state of the enable signal.

It should be noted that mixed embodiments are possible as well, which on the one hand means that parts of the logic function 5, 5a..5c may be embodied by means of the look up table 7 whereas other parts are embodied by means of the logic circuit 8a, 8b. On the other hand, this means that part of the logic function 5, 5a..5c may be based on positive logic whereas other parts may be based on negative logic.

For example, the third logic input LIN3 for the enable signal can be inverted in a logic function 5 based on positive logic (see Fig. 2). Accordingly, the look up table or truth table 7 based on such a logic can look like as shown below.

| LIN3 | LIN2 | LIN1 | LOUT |
|---|---|---|---|
| 0 | 0 | 0 | 0 |
| 0 | 0 | 1 | 1 |
| 0 | 1 | 0 | 0 |
| 0 | 1 | 1 | 1 |
| 1 | 0 | 0 | 0 |
| 1 | 0 | 1 | 1 |
| 1 | 1 | 0 | 0 |
| 1 | 1 | 1 | 0 |

It should be noted that states where a data bit is sent but none is received (or in other words, in case of positive logic, states where the second logic input LIN2 is high and the first logic input LIN1 is low) are logically impossible. So, the second and sixth lines in the aforementioned look up table 7 and its pendant based on negative logic as well as the third and seventh line in the above table should not exist. In these cases, the logic output LOUT may also be switched inactive or to a high impedance state respectively. Accordingly, the corresponding table cells may contain the symbols "X" or "Z". Nevertheless, said states can be used to detect a malfunction in the electronic interface 1.

Further on, Fig. 5 shows a cutout of another example of an electronic interface 1a, which is very similar to the electronic interface 1 of Fig. 1. The only difference is that the line output LNOUT of the sender unit 3 and the line input LNIN of the receiver unit 4 are internally connected within the electronic interface 1a. Anyway, an optional external connection is possible as well.

Further on, Fig. 6 shows a cutout of another example of an electronic interface 1b, which is very similar to the electronic interface 1a of Fig. 5. The only difference is that the connection between the line output LNOUT of the sender unit 3 and the line input LNIN of the receiver unit 4 is made by use of a switch S so that the line output LNOUT can be connected to the line input LNIN on demand.

Further on, Fig. 7 shows a schematic view of an exemplary communication system 9a with a first electronic interface 1 which is embodied as disclosed hereinbefore, a second electronic interface 1' and a bidirectional one-wire communication line 2 connecting the first electronic interface 1 with the second electronic interface 1'. In detail, the line output LNOUT of the sender unit 3 and the line input LNIN of the receiver unit 4 of the first electronic interface 1 are connected to the one-wire communication line 2. Generally, the second electronic interface 1' comprises
- a sender unit 3' with a line output LNOUT', which is (physically) connected to the one-wire communication line 2,
- a receiver unit 4' with a line input LNIN', which is (physically) connected to the one-wire communication line 2',
- a data input DIN' for a data signal having sending data bits, which are to be sent over the one-wire communication line 2 via the sender unit 3', and
- a data output DOUT' for a data signal having received data bits, which are received over the one-wire communication line 2' via the receiver unit 4'.

Advantageously, the second electronic interface 1' can be designed to forward a feedback bit, which is sent by the sender unit 3' and fed back to and received by the receiver unit 4' of the second electronic interface 1', to the data output DOUT' of the second electronic interface 1' only on demand. In particular, the second electronic interface 1' may also be embodied as disclosed hereinbefore by use of the Figs. 1 to 4. More particularly, the first electronic interface 1 and the second electronic interface 1' may have the same structure and may be embodied identically.

The communication system 9a can comprise
- a first application circuit 10 connected to the first electronic interface 1 via the data input DIN and the data output DOUT of the first electronic interface 1 and/or
- a second application circuit 10' connected to the second electronic interface 1' via the data input DIN' and the data output DOUT' of the second electronic interface 1' like this is depicted in Fig. 7.

More particularly,
- the first application circuit 10 can also be connected to the first electronic interface 1 via the enable input EN of the first electronic interface 1 and/or
- the second application circuit 10' can also be connected to the second electronic interface 1' via the enable input EN' of the second electronic interface 1'
like this is depicted in Fig. 7 as well.

Finally, Fig. 8 shows a schematic view of another exemplary communication system 9b, which is similar to the communication system 9a of Fig. 7. In contrast, a plurality of second electronic interfaces 1'..1‴ each with a second application circuit 10'..10‴ coupled thereto is connected to the first electronic interface 1 via the one-wire communication line 2. In Fig. 8 there are three second electronic interfaces 1'..1‴ with three second application circuits 10'..10‴. However, any other number of second electronic interfaces 1'..1‴ and second application circuits 10'..10"' is possible as well. A further difference is that the electronic interfaces 1..1‴ and the application circuits 10..10‴ are connected via optional ground lines GND..GND‴ in this embodiment.

Generally, the electronic interface(s) 1..1‴ can be seen or embodied as a universal asynchronous receiver-transmitter (UART). Moreover, signal levels the one-wire communication line 2 in particular can be set or chosen according to standards RS-232, RS-485, and raw TTL.

It should be noted that the electronic interface 1..1‴ and the associated application circuit 10..10‴ may be embodied as separate physical modules or in a common physical module, in particular on separate circuit boards or on a common circuit board. It should also be noted that the first application circuit 10 and its first electronic interface 1 and the second application circuit 10'..10‴ and its second electronic interface 1'..1‴ can be arranged on separate circuit boards or on a common circuit board. In the latter case, the one-wire communication line 2 can be seen as an intra-module communication line.

By use of the proposed measures, generally, forwarding feedback data to the data output DOUT..DOUT‴ can be blocked so that an application circuit 10..10‴ or a receiving software provided for processing received data does not even receive feedback data. Hence, during normal operation, the application circuit 10..10‴ or a receiving software does only receive foreign bits and no complicated software blocking is needed. On the other hand, if needed, testing the sending and receiving branch of the electronic interface 1..1‴ and the one-wire communication line 2 is possible if forwarding feedback data is enabled. In a nutshell, the proposed measures allow for easy handling of feedback data and for both processing received data during normal operation and for testing with only low requirements on the software of an application circuit 10..10‴ connected to the electronic interface 1..1‴.

Finally, one should note that the invention is not limited to the above-mentioned embodiments and exemplary working examples. Further developments, modifications and combinations are also within the scope of the patent claims and are placed in the possession of the person skilled in the art from the above disclosure. Accordingly, the techniques and structures described and illustrated herein should be understood to be illustrative and exemplary, and not limiting upon the scope of the present invention. The scope of the present invention is defined by the appended claims, including known equivalents and unforeseeable equivalents at the time of filing of this application. Although numerous embodiments of this invention have been described above with a certain degree of particularity, those skilled in the art could make numerous alterations to the disclosed embodiments without departing from the spirit or scope of this disclosure.

### List of references

- 1..1"', 1a, 1b: electronic interface
- 2: one-wire communication line (data bus)
- 3, 3': sender unit
- 4, 4': receiver unit
- 5, 5', 5a..5c: logic function
- 6, 6': filter
- 7: look up table
- 8a, 8b: logic circuit
- 9a, 9b: communication system
- 10..10‴: application circuit

- DIN..DIN‴: data input
- DOUT..DOUT‴: data output
- EN..EN‴: enable input
- GND..GND‴: ground line
- LNIN, LNIN': line input
- LNOUT, LNOUT': line output
- LIN1..LIN3: logic input
- LOUT: logic output
- S: switch

## Claims

1. Electronic interface (1..1‴, 1a, 1b) for a bidirectional one-wire communication line (2), comprising
- a sender unit (3, 3') with a line output (LNOUT, LNOUT'), which is designed to be connected to the one-wire communication line (2),
- a receiver unit (4, 4') with a line input (LNIN, LNIN'), which is designed to be connected to the one-wire communication line (2),
- a data input (DIN..DIN"') for a data signal having sending data bits, which are to be sent over the one-wire communication line (2) via the sender unit (3, 3'), and
- a data output (DOUT..DOUT‴) for a data signal having received data bits, which are received over the one-wire communication line (2) via the receiver unit (4, 4'),
- wherein the electronic interface (1..1‴, 1a, 1b) is designed to forward a feedback bit, which is sent by the sender unit (3, 3') and fed back to and received by the receiver unit (4, 4'), to the data output (DOUT..DOUT‴),
**characterized in that**
- the electronic interface (1..1"', 1a, 1b) is designed to forward a feedback bit to the data output (DOUT..DOUT‴) only on demand.

2. Electronic interface (1..1"', 1a, 1b) as claimed in claim 1, **characterized in that** the electronic interface (1..1‴, 1a, 1b) is designed to forward to the data output (DOUT..DOUT"') a foreign bit, which is received by the receiver unit (4, 4') and does not originate from the sender unit (3, 3'), independent of if the feedback bit is forward to the data output (DOUT..DOUT‴) or not.

3. Electronic interface (1..1"', 1a, 1b) as claimed in claim 1 or 2, **characterized in that** the electronic interface (1..1‴, 1a, 1b) comprises an enable input (EN..EN‴) and is designed to forward the feedback bit to the data output (DOUT..DOUT‴) dependent on the logic state of an enable signal at the enable input (EN..EN‴).

4. Electronic interface (1..1‴, 1a, 1b) as claimed in claim 3, **characterized in that** the electronic interface (1..1‴, 1a, 1b) is designed to forward the foreign bit to the data output (DOUT..DOUT"') independently of the logic state of the enable signal.

5. Electronic interface (1..1‴, 1a, 1b) as claimed in any one of claims 1 to 4, **characterized in that** the electronic interface (1..1‴, 1a, 1b) in a case a) comprises a look up table (7) or in a case b) comprises a logic circuit (8a, 8b) each with a first logic input (LIN1) for the received data bits, a second logic input (LIN2) for the sending data bits, a third logic input (LIN3) for the enable signal and a logic output (LOUT) for the data output (DOUT..DOUT‴), wherein the table content of the look up table (7) in case a) or the logic function (5, 5', 5a..5c) of the logic circuit (8a, 8b) in case b) based on positive logic is
| LIN3 (EN) | LIN2 (DIN) | LIN1 (LNIN) | LOUT (DOUT) |
|---|---|---|---|
| 1 | 1 | 1 | 1 |
| 1 | 1 | 0 | 0 |
| 1 | 0 | 1 | 1 |
| 1 | 0 | 0 | 0 |
| 0 | 1 | 1 | 0 |
| 0 | 1 | 0 | 0 |
| 0 | 0 | 1 | 1 |
| 0 | 0 | 0 | 0 |
or based on negative logic is
| LIN3 (EN) | LIN2 (DIN) | LIN1 (LNIN) | LOUT (DOUT) |
|---|---|---|---|
| 0 | 0 | 0 | 0 |
| 0 | 0 | 1 | 1 |
| 0 | 1 | 0 | 0 |
| 0 | 1 | 1 | 1 |
| 1 | 0 | 0 | 1 |
| 1 | 0 | 1 | 1 |
| 1 | 1 | 0 | 0 |
| 1 | 1 | 1 | 1 |

6. Communication system (9a, 9b), **characterized by**
- an electronic interface (1..1‴, 1a, 1b) as claimed in any one of claims 1 to 5, which forms a first electronic interface (1),
- a bidirectional one-wire communication line (2), which the line output (LNOUT) of the sender unit (3) and the line input (LNIN) of the receiver unit (4) of the first electronic interface (1) are connected to, and
- at least one second electronic interface (1'..1‴), having
- ) a sender unit (3') with a line output (LNOUT'), which is connected to the one-wire communication line (2),
- ) a receiver unit (4') with a line input (LNIN'), which is connected to the one-wire communication line (2'),
- ) a data input (DIN'..DIN‴) for a data signal having sending data bits, which are to be sent over the one-wire communication line (2) via the sender unit (3'), and
- ) a data output (DOUT'..DOUT‴) for a data signal having received data bits, which are received over the one-wire communication line (2') via the receiver unit (4').

7. Communication system (9a, 9b) as claimed in claim 6, **characterized in that** the at least one second electronic interface (1'..1‴) is designed to forward a feedback bit, which is sent by the sender unit (3') and fed back to and received by the receiver unit (4') of the at least one second electronic interface (1'..1‴), to the data output (DOUT'..DOUT‴) of the at least one second electronic interface (1'..1‴) only on demand.

8. Communication system (9a, 9b) as claimed in claim 6 or 7, **characterized in**
- a first application circuit (10) connected to the first electronic interface (1) via the data input (DIN) and the data output (DOUT) of the first electronic interface (1) and/or
- at least one second application circuit (10'..10‴) connected to the at least one second electronic interface (1'..1‴) via the data input (DIN'..DIN‴) and the data output (DOUT'..DOUT‴) of the at least one second electronic interface (1'..1‴).

9. Communication system (9a, 9b) as claimed in claim 8, wherein
- the first electronic interface (1) is embodied as claimed in any one of claims 3 to 5 and the first application circuit (10) is connected to the first electronic interface (1) via the enable input (EN) of the first electronic interface (1) and/or
- the at least one second electronic interface (1'..1‴) is embodied as claimed in any one of claims 3 to 5 and the at least one second application circuit (10'..10‴) is connected to the at least one second electronic interface (1'..1‴) via the enable input (EN'..EN‴) of the at least one second electronic interface (1'..1‴).

10. Method for sending and receiving data over a bidirectional one-wire communication line (2) by means of an electronic interface (1..1‴, 1a, 1b) having a sender unit (3, 3'), a receiver unit (4, 4'), a data input (DIN..DIN‴) and a data output (DOUT..DOUT‴), in particular by means of an electronic interface (1..1‴, 1a, 1b) as claimed in any one of the claims 1 to 5, comprising the steps
- sending over the one-wire communication line (2) via the sender unit (3, 3'), which is connected to the one-wire communication line (2) with a line output (LNOUT, LNOUT'), a data signal having sending data bits, wherein the sending data bits are input at a data input (DIN..DIN‴) of the electronic interface (1..1‴, 1a, 1b),
- receiving a data signal having received data bits, which are received over the one-wire communication line (2) via the receiver unit (4, 4'), which is connected to the one-wire communication line (2) with a line input (LNIN, LNIN'), wherein the received data bits are output at the data output (DOUT..DOUT‴), and
- forwarding to the data output (DOUT..DOUT‴) a feedback bit, which is sent by the sender unit (3, 3') and fed back to and received by the receiver unit (4, 4'), only on demand.

11. Method as claimed in claim 10, **characterized by** forwarding to the data output (DOUT..DOUT"') a foreign bit, which is received by the receiver unit (4, 4') and does not originate from the sender unit (3, 3'), independent of if the feedback bit is forward to the data output (DOUT..DOUT‴) or not.

12. Method as claimed in claim 10 or 11, **characterized by** forwarding the feedback bit to the data output (DOUT..DOUT‴) dependent on the logic state of an enable signal at an enable input (EN..EN‴) of the electronic interface (1..1‴, 1a, 1b).

13. Method as claimed in claim 12, **characterized by** forwarding the foreign bit to the data output (DOUT..DOUT‴) independently of the logic state of the enable signal.

14. Method as claimed in any one of claims 10 to 13, **characterized in that** the feedback bit and the foreign bit are forwarded to the data output (DOUT..DOUT‴) based on a logic function (5, 5', 5a..5c) with a first logic input (LIN1) for the received data bits, a second logic input (LIN2) for the sending data bits, a third logic input (LIN3) for the enable signal and a logic output (LOUT) for the data output (DOUT..DOUT‴), wherein the logic function (5, 5', 5a..5c) based on positive logic is
| LIN3 (EN) | LIN2 (DIN) | LIN1 (LNIN) | LOUT (DOUT) |
|---|---|---|---|
| 1 | 1 | 1 | 1 |
| 1 | 1 | 0 | 0 |
| 1 | 0 | 1 | 1 |
| 1 | 0 | 0 | 0 |
| 0 | 1 | 1 | 0 |
| 0 | 1 | 0 | 0 |
| 0 | 0 | 1 | 1 |
| 0 | 0 | 0 | 0 |
or based on negative logic is
| LIN3 (EN) | LIN2 (DIN) | LIN1 (LNIN) | LOUT (DOUT) |
|---|---|---|---|
| 0 | 0 | 0 | 0 |
| 0 | 0 | 1 | 1 |
| 0 | 1 | 0 | 0 |
| 0 | 1 | 1 | 1 |
| 1 | 0 | 0 | 1 |
| 1 | 0 | 1 | 1 |
| 1 | 1 | 0 | 0 |
| 1 | 1 | 1 | 1 |
